# EUROPEAN PATENT APPLICATION

(11) **EP 4 443 507 A1**
(43) Date of publication of application: **09.10.2024**
(21) Application number: 22904547.1
(22) Date of filing: 28.11.2022
(51) Int. Cl.: H01L 27/12

(54) **DISPLAY DEVICE COMPRISING SEMICONDUCTOR LIGHT EMITTING ELEMENT**

(30) Priority: 08.12.2021 KR 20210174469
(71) Applicant: LG Electronics Inc., Yeongdeungpo-gu Seoul 07336 (KR); LG Display Co., Ltd., Seoul 07336 (KR)
(72) Inventor: KIM, Youngdo, Seoul 06772 (KR); JANG, Hun, Paju-si Gyeonggi-do 10845 (KR); NAM, Juhyun, Paju-si Gyeonggi-do 10845 (KR); EOM, Hyeseon, Paju-si Gyeonggi-do 10845 (KR); KIM, Minseok, Paju-si Gyeonggi-do 10845 (KR)
(74) Representative: Vossius & Partner Patentanwälte Rechtsanwälte mbB
(86) International application number: PCT/KR2022/018939
(87) International publication number: WO 2023/106714

(57) **Abstract**

A display device according to an embodiment includes a substrate, first assembly wiring and second assembly wiring spaced apart from each other on the substrate, a first insulating layer disposed between the first assembly wiring and the second assembly wiring, a first planarization layer disposed on the second assembly wiring and having an opening overlapping the second assembly wiring, a light emitting device disposed inside the opening and including a first semiconductor layer and a second semiconductor layer on the first semiconductor layer, and contact electrode electrically connecting the second assembly wiring and the first semiconductor layer, and the contact electrode is in contact with the second assembly wiring that overlaps the side surface of the first semiconductor layer and the first planarization layer.

## Description

### [Technical Field]

The present invention relates to a display device, and more specifically, to a display device using a semiconductor light emitting device.

### [Background Art]

In display devices used in computer monitors, TVs, mobile phones, etc., there are organic light emitting displays (OLED) that emit light on their own, liquid crystal displays (LCD) and micro-LED displays that require a separate light source.

Micro-LED displays are displays that use micro-LEDs, semiconductor light emitting devices with a diameter or cross-sectional area of 100*µ*m or less, as display elements.

Micro-LED displays have excellent performance in many characteristics such as contrast ratio, response speed, color reproducibility, viewing angle, brightness, resolution, lifespan, luminous efficiency, and brightness because they use micro-LEDs, semiconductor light emitting devices, as display elements.

In particular, micro-LED displays have the advantage of being able to freely adjust size and resolution because the screen may be separated and combined in a modular manner, and the advantage of being able to implement flexible displays.

However, since large micro-LED displays require millions or more micro-LEDs, there is a technical problem that makes it difficult to quickly and accurately transfer micro-LEDs to the display panel. Meanwhile, there are methods for transferring semiconductor light emitting devices to a substrate, such as the pick and place process, the laser lift-off method, or the self-assembly method.

Among these, the self-assembly method is advantageous for implementing a large-screen display device as it is a method in which semiconductor light emitting devices find their assembly positions within a fluid on their own.

Meanwhile, when light emitting devices are transferred within a fluid, there is a problem in which the assembly wiring is corroded by the fluid. Corrosion of the assembly wiring may cause an electrical short circuit and cause assembly failure. In addition, it is important to improve the assembly force for assembling light emitting devices into the assembly holes during self-assembly.

### [Disclosure]

### [Technical Problem]

The technical object of the embodiment is to provide a display device that may use a pair of assembly wirings to which different voltages are applied as electrodes connecting the first semiconductor layer of the light emitting device and the driving transistor during self-assembly of the light emitting device.

In addition, the technical object of the embodiment is to provide a display device that may improve the assembly rate of the light emitting device by symmetrically arranging different types of assembly wirings to reduce the electric field biased toward the barrier wall.

In addition, the technical object of the embodiment is to provide a display device that may connect the light emitting device and the assembly wiring without an additional process by exposing the assembly wiring outside the passivation layer.

In addition, the technical object of the embodiment is to provide a display device that may drive the light emitting device even at a low voltage.

In addition, the technical object of the embodiment is to provide a display device that may prevent electrical shorting between the contact electrode and the pixel electrode.

The objects of the embodiment are not limited to the objects mentioned above, and other problems that are not mentioned may be clearly understood by those skilled in the art from the description below.

### [Technical Solution]

A display device including a semiconductor light emitting device according to an embodiment may include a substrate; first assembly wiring and second assembly wiring spaced apart from each other on the substrate; a first insulating layer arranged between the first assembly wiring and the second assembly wiring; a first planarization layer arranged on the second assembly wiring and having an opening overlapping the second assembly wiring; a light emitting device arranged inside the opening and including a first semiconductor layer and a second semiconductor layer on the first semiconductor layer; and a contact electrode electrically connecting the second assembly wiring and the first semiconductor layer, and the contact electrode may contact a side surface of the first semiconductor layer and the second assembly wiring overlapping the first planarization layer.

In addition, in the embodiment, the light emitting device may overlap the first assembly wiring.

In addition, in the embodiment, the first assembly wiring may be made of the same material as the second assembly wiring.

In addition, in the embodiment, the upper portion of the second assembly wiring may be in contact with the first planarization layer, and the side surface of the second assembly wiring may be in contact with the contact electrode.

In addition, in the embodiment, the contact electrode may be arranged on the side surface of the first planarization layer and the side surface of the second assembly wiring inside the opening.

In addition, the embodiment further includes a second planarization layer arranged on the first planarization layer.

And the light emitting device may further include an auxiliary electrode connected to the second semiconductor layer and exposed by the second planarization layer.

In addition, in the embodiment, the first assembly wiring and the second assembly wiring may be in a stripe shape, and the second assembly wiring may be arranged on both sides with the first assembly wiring in the middle.

In addition, in the embodiment, the first assembly wiring may include a first portion in a stripe shape and a second portion branched from the first portion and having a circle shape, and the second assembly wiring may include a third portion in a stripe shape and a fourth portion in a donut shape branched from the third portion and surrounding a part of the second portion.

In addition, a display device including a semiconductor light emitting device according to an embodiment may include a substrate, first assembly wiring and second assembly wiring alternately arranged on the substrate and spaced apart from each other, a planarization layer arranged on the second assembly wiring and having an opening; a light emitting device arranged inside the opening and including a first semiconductor layer and a second semiconductor layer on the first semiconductor layer; and a contact electrode connecting the second assembly wiring and the first semiconductor layer of the light emitting device within the opening, and the first assembly wiring overlaps the light emitting device, and a side surface of the second assembly wiring may be arranged parallel to a side surface of the planarization layer.

In addition, the embodiment may further include a contact electrode arranged in contact with a side surface of the planarization layer, the second assembly wiring, and the first semiconductor layer.

In addition, the embodiment may further include an insulating layer disposed on the first assembly wiring to insulate the first assembly wiring and the second assembly wiring.

In addition, in the embodiment, the second assembly wiring may be spaced apart from the first assembly wiring by a predetermined distance.

In addition, in the embodiment, the first assembly wiring may include a first part and a second part having different shapes, and the second assembly wiring may include a third part and a fourth part having different shapes.

In addition, in the embodiment, the first part and the third part may have the same shape, and the second part and the fourth part may have different shapes.

In addition, in the embodiment, the fourth part may surround a part of the second part.

In addition, in the embodiment, the first part and the third part may overlap the opening, and the second part and the fourth part may overlap the flattening layer.

In addition, the embodiment further includes a structure disposed within the first flattening layer, and the second assembly electrode may be disposed on the structure.

In addition, in the embodiment, the contact electrode may be in contact with the upper surface and the side surface of the second assembly electrode.

In addition, the embodiment may further include a second insulating layer disposed on the contact electrode.

In addition, in the embodiment, the contact electrode and the second insulating layer may surround the light emitting device.

### [Advantageous Effects]

According to the embodiment, there is a technical effect that the wiring for self-assembly of the light emitting device may also be utilized as the wiring for driving the light emitting device.

In addition, the embodiment has a technical effect that the short-circuit defect of the assembly wiring may be reduced by arranging the assembly wiring on different layers, and the assembly rate of the light emitting device may be improved by finely adjusting the gap between the assembly wiring.

In addition, the embodiment has a technical effect that the light emitting device may be improved from being biased to one side and causing an assembly defect by arranging the assembly wiring in a symmetrical structure using the assembly wiring.

In addition, the embodiment has a technical effect that the process of forming a passivation layer contact hole for connecting the first semiconductor layer of the light emitting device and the assembly wiring may be reduced by forming the assembly wiring so that it is exposed on the side of the barrier wall.

In addition, the embodiment has a technical effect of increasing the contact area of the contact electrode and the assembly wiring to increase the current amount and drive the light emitting device even at a low voltage.

In addition, the embodiment has a technical effect of preventing an electrical short between the contact electrode and the pixel electrode.

The effect according to the embodiment is not limited to the contents exemplified above, and more diverse effects are included in the present invention.

### [Description of Drawings]

FIG. 1 is a schematic plan view of a display device according to an embodiment.
FIG. 2 is a schematic enlarged plan view of a display device according to an embodiment.
FIG. 3 is a cross-sectional view of a display device according to an embodiment.
FIGS. 4A to 4C are process diagrams for explaining a manufacturing method of a display device according to an embodiment.
FIGS. 5A to 5E are process diagrams for explaining a contact electrode forming process of a display device according to an embodiment.
FIG. 6 is a schematic enlarged plan view of FIG. 4b.
FIG. 7 is a cross-sectional view of a display device according to a second embodiment.
FIGS. 8A and 8N are schematic enlarged plan views of a display device according to a second embodiment.
FIGS. 9A to 9E are process diagrams for explaining a manufacturing method of a display device according to a second embodiment.
FIG. 10 is a cross-sectional view of a display device according to a third embodiment.
FIG. 11 is a cross-sectional view of a display device according to the fourth embodiment.

### [Mode for Invention]

Hereinafter, the embodiments disclosed in the present specification will be described in detail with reference to the attached drawings. The suffixes 'module' and 'part' used in the following description for components are given or used interchangeably in consideration of the ease of writing the specification, and do not have distinct meanings or roles in themselves. In addition, the attached drawings are provided to facilitate easy understanding of the embodiments disclosed in the present specification, and the technical ideas disclosed in the present specification are not limited by the attached drawings. In addition, when an element such as a layer, region, or substrate is mentioned as existing 'on' another element, this includes that it may be directly on the other element, or that other intermediate elements may exist therebetween.

The display device described in this specification may include a digital TV, a mobile phone, a smart phone, a laptop computer, a digital broadcasting terminal, a personal digital assistant (PDA), a portable multimedia player (PMP), a navigation, a slate PC, a tablet PC, an Ultra-Book, a desktop computer, etc. However, the configuration according to the embodiment described in this specification may be applied to a device capable of displaying, even if it is a new product type developed in the future.

Hereinafter, the embodiment will be described with reference to the drawings.

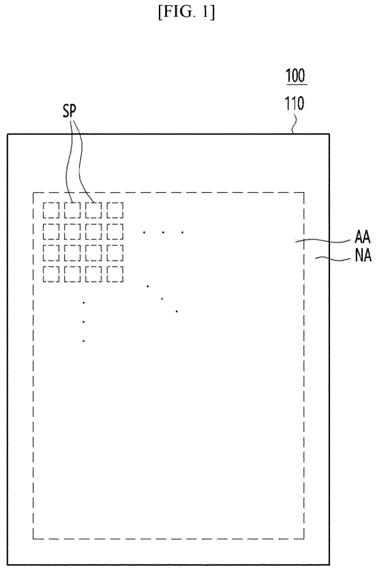

FIG. 1 is a schematic plan view of a display device according to an embodiment. In FIG. 1, only the substrate 110 and a plurality of sub-pixels (SP) among various components of the display device (100) are illustrated for convenience of explanation.

The display device 100 according to the embodiment may include a flexible display manufactured on a thin and flexible substrate. The flexible display may be bent or rolled like paper while maintaining the characteristics of a conventional flat panel display.

In a flexible display, visual information may be implemented by independently controlling the light emission of unit pixels arranged in a matrix form. A unit pixel means a minimum unit for implementing one color. A unit pixel of a flexible display may be implemented by a light emitting device. In an embodiment, the light emitting device may be a Micro-LED or a Nano-LED, but is not limited thereto. The substrate 110 is configured to support various components included in the display device 100 and may be made of an insulating material. For example, the substrate 110 may be made of glass or resin. Additionally, the substrate 110 may include polymer or plastic, or may be made of a material with flexibility.

The substrate 110 includes a display area (AA) and a non-display area (NA).

The display area (AA) is an area where multiple sub-pixels (SPs) are arranged and an image is displayed. Each of the plurality of sub-pixels (SP) is an individual unit that emits light, and a light emitting device 130 and a driving circuit are formed in each of the plurality of sub-pixels (SP). For example, the multiple sub-pixels (SPs) may include a red sub-pixel (SP), a green sub-pixel (SP), a blue sub-pixel (SP), and/or a white sub-pixel (SP), but are not limited thereto. Hereinafter, it will be assumed that the multiple sub-pixels (SPs) include a red sub-pixel (SP), a green sub-pixel (SP), and a blue sub-pixel (SP), but are not limited thereto.

The non-display area (NA) is an area where an image is not displayed, and is an area where various wiring, driving ICs, etc. for driving the sub-pixels (SPs) arranged in the display area (AA) are arranged. For example, various ICs such as a gate driver IC and a data driver IC, and driving circuits, etc. may be arranged in the non-display area (NA). Meanwhile, the non-display area (NA) may be located on the back surface of the substrate (110), i.e., on a surface where there is no sub-pixel (SP), or may be omitted, and is not limited to that shown in the drawing.

The active matrix (AM, Active Matrix) of the 100-series DT-100 may be used to control the active matrix (PM, Passive Matrix) of the DT-100.

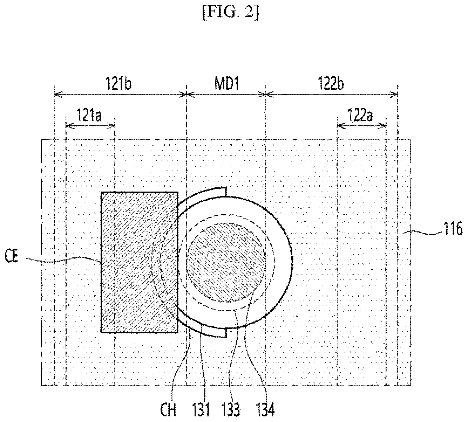

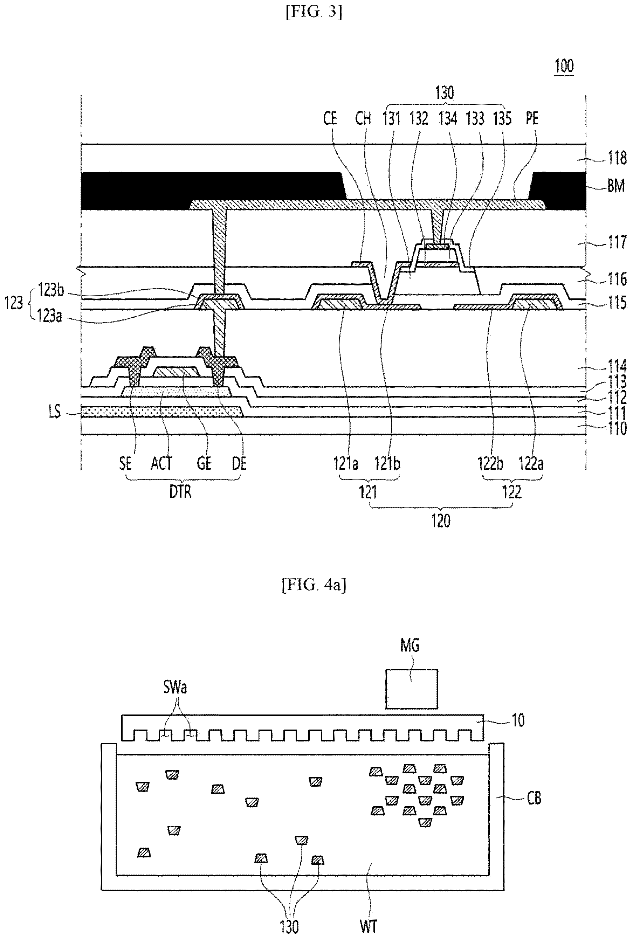

Hereinafter, referring to FIGS. 2 and 3 together for a more detailed description of a plurality of sub-pixels SP.

FIG. 2 is a schematic enlarged plan view of a display device according to an embodiment. FIG. 3 is a cross-sectional view of a display device according to an embodiment. Referring to FIGS. 2 and 3, the display device 100 according to the embodiment may include a substrate 110, a buffer layer 111, a gate insulating layer 112, a first passivation layer 113, a first planarization layer 114, a second passivation layer 115, second planarization layer 116, third planarization layer 117, protective layer 118, black matrix (BM), light blocking layer (LS), driving transistor (DTR), semiconductor light emitting device 130, assembly wiring 120, connection electrode 123, contact electrode (CE), and pixel electrode (PE), etc.

Referring to FIGS. 2 and 3, a light-shielding layer (LS) may be placed on the substrate 110. The light-shielding layer (LS) blocks light incident on the active layer (ACT) of the driving transistor (DTR) to be described later from the lower portion of the substrate 110. Light incident on the active layer (ACT) of the driving transistor (DTR) is blocked by the light-shielding layer (LS), thereby minimizing leakage current.

The buffer layer 111 may be disposed on the substrate 110 and the light blocking layer LS. The buffer layer 111 may reduce penetration of moisture or impurities through the substrate 110. The buffer layer 111 may be composed of, for example, a single layer or a multiple layer of silicon oxide (SiOx) or silicon nitride (SiNx), but is not limited thereto. However, the buffer layer 111 may be omitted depending on the type of substrate 110 or the type of transistor, but is not limited thereto.

A driving transistor (DTR) may be disposed on the buffer layer 111. The driving transistor (DTR) includes an active layer (ACT), a gate electrode (GE), a source electrode (SE), and a drain electrode (DE).

The active layer (ACT) may be disposed on the buffer layer 111. The active layer (ACT) may be made of a semiconductor material such as an oxide semiconductor, amorphous silicon, or polysilicon, but is not limited thereto.

The gate insulating layer 112 may be disposed on the active layer (ACT). The gate insulating layer 112 is an insulating layer for insulating the active layer (ACT) and the gate electrode (GE), and may be composed of a single layer or multiple layers of silicon oxide (SiOx) or silicon nitride (SiNx), but is not limited thereto.

A gate electrode (GE) is disposed on the gate insulating layer 112. The gate electrode (GE) may be electrically connected to the source electrode (SE) of the driving transistor (DTR). The gate electrode (GE) may be composed of a conductive material, for example, copper (Cu), aluminum (Al), molybdenum (Mo), nickel (Ni), titanium (Ti), chromium (Cr), or an alloy thereof, but is not limited thereto.

The first passivation layer 113 may be disposed on the gate electrode GE. Contact holes are formed in the first passivation layer 113 to connect the source electrode (SE) and the drain electrode (DE) to the active layer (ACT). The first passivation layer 113 is an insulating layer to protect the structure below the first passivation layer 113, and may be composed of a single layer or multiple layers of silicon oxide (SiOx) or silicon nitride (SiNx), but is not limited thereto.

A source electrode (SE) and a drain electrode (DE) electrically connected to the active layer (ACT) may be disposed on the first passivation layer (113). The source electrode (SE) and the drain electrode (DE) may be composed of a conductive material, for example, copper (Cu), aluminum (Al), molybdenum (Mo), nickel (Ni), titanium (Ti), chromium (Cr), or an alloy thereof, but are not limited thereto.

The first planarization layer 114 may be disposed on the driving transistor (DTR). The first planarization layer 114 may planarize the upper portion of the substrate 110 on which the plurality of transistors are disposed. The first planarization layer 114 may be composed of a single layer or a double layer, and may be made of, for example, an acryl-based organic material, but is not limited thereto.

A plurality of first assembly wirings 121, a plurality of second assembly wirings 122, and a connection electrode 123 may be disposed on the first planarization layer 114.

First, the plurality of assembly wirings 120 are wires that generate an electric field for aligning the plurality of light emitting devices 130 when manufacturing the display device 100 and supply a low-potential power voltage to the plurality of light emitting devices 130 when driving the display device 100. Accordingly, the assembly wirings 120 may be referred to as low-potential power wires. The plurality of assembly wirings 120 are arranged in a column direction along the plurality of sub-pixels (SP) arranged in the same line. The plurality of assembly wirings 120 may be arranged to overlap the plurality of sub-pixels (SP) arranged in the same column. For example, one first assembly wiring 121 and one second assembly wiring 122 may be arranged in the sub-pixel (SP) arranged in the same column.

The plurality of assembly wirings 120 may include a plurality of first assembly wirings 121 and a plurality of second assembly wirings 122. When the display device 100 is driven, the same low-potential voltage may be applied as an alternating current to the plurality of first assembly wirings 121 and the plurality of second assembly wirings 122. The plurality of first assembly wirings 121 and the plurality of second assembly wirings 122 may be arranged alternately. In addition, in each of the plurality of sub-pixels (SP), one first assembly wiring 121 and one second assembly wiring 122 may be arranged adjacent to each other.

The plurality of first assembly wirings 121 and the plurality of second assembly wirings 122 may be made of a conductive material, for example, copper (Cu) and chromium (Cr), but are not limited thereto.

The plurality of first assembly wirings 121 include a first conductive layer 121a and a first clad layer 121b. The first conductive layer 121a may be disposed on the first planarization layer 114. The first clad layer 121b may be in contact with the first conductive layer 121a. For example, the first clad layer 121b may be disposed to cover the upper surface and side surfaces of the first conductive layer 121a. And the first conductive layer 121a may have a thickness thicker than the first clad layer 121b.

The first clad layer 121b is made of a material more resistant to corrosion than the first conductive layer 121a, so that, when manufacturing a display device 100, there is a technical effect that may minimize a short circuit defect due to migration between the first conductive layer 121a of the first assembly wiring 121 and the second conductive layer 122a of the second assembly wiring 122. For example, the first clad layer 121b may be made of molybdenum (Mo), molybdenum titanium (MoTi), etc., but is not limited thereto.

Each of the plurality of second assembly wirings 122 is disposed in a plurality of sub-pixels (SP) arranged on the same line as described above, and the plurality of first assembly wirings 121 and the plurality of second assembly wirings 122 may be arranged spaced apart from each other.

Each of the plurality of second assembly wirings 122 may include a second conductive layer 122a and a second clad layer 122b. The second conductive layer 122a may be disposed on the first planarization layer 114. And the second clad layer 122b may be electrically connected to the second conductive layer 122a. For example, the second clad layer 122b may be disposed to cover the top and side surfaces of the second conductive layer 122a. And the second conductive layer 122a may have a thickness greater than that of the second clad layer 122b.

The second clad layer 122b, like the first clad layer 121b, is also made of a material that is more resistant to corrosion than the second conductive layer 122a, when manufacturing the display device 100, short-circuit defects due to migration between the first assembly wiring 121 and the second assembly wiring 122 may be minimized. For example, the second clad layer 122b may be made of molybdenum (Mo), molybdenum titanium (MoTi), etc., but is not limited thereto.

The first clad layer 121b and the second clad layer 122b have a first separation distance MD1. As the first separation distance MD1 is smaller, the assembly rate of the light emitting device 130 may be improved. However, since the first clad layer 121b and the second clad layer 122b are disposed on the same layer, a process margin exists and there is a limit to reducing the first separation distance MD1. A method to solve this will be described later.

A connection electrode 123 is disposed in each of the plurality of sub-pixels SP. The connection electrode 123 is an electrode for electrically connecting the light emitting device 130 and the driving transistor (DTR), and includes a first connection layer 123a and a second connection layer 123b. The connection electrode 123 may be electrically connected to either the source electrode (SE) or the drain electrode (DE) of the driving transistor (DTR) through a contact hole formed in the first planarization layer (114). For example, the first connection layer 123a may be formed on the same layer and made of the same material as the first conductive layer 121a of the first assembly wiring 121, and may be electrically connected to the driving transistor (DTR) through a contact hole formed in the first planarization layer 114. And the second connection layer 123b is formed of the same material on the same layer as the first clad layer 121b, and may cover the top and side surfaces of the first connection layer 123a.

The second passivation layer 115 is disposed on the first assembly wiring 121, the second assembly wiring 122, and the connection electrode 123. The second passivation layer 115 is an insulating layer to protect the structure below the second passivation layer 115, and may be composed of a single layer or multiple layers of silicon oxide (SiOx) or silicon nitride (SiNx), but is not limited thereto. In addition, the second passivation layer 115 may function as an insulating layer to prevent short circuit defects or corrosion between the first assembly wiring 121 and the second assembly wiring 122 when manufacturing the display device 100.

Next, the second planarization layer 116 may be disposed on the plurality of second assembly wirings 122. The second planarization layer 116 may be composed of a single layer or a double layer, and may be made of, for example, an acryl-based organic material, but is not limited thereto.

Meanwhile, the second planarization layer 116 fixes the plurality of light emitting devices 130 to the TFT substrate and includes a plurality of contact holes (CH) for connecting the light emitting devices 130 and assembly wiring. A plurality of contact holes (CH) may be disposed in each of the plurality of sub-pixels (SP). The contact hole (CH) may be shaped like a half donut exposing one side of the light emitting device 130, but is not limited to this and the shape of the contact hole (CH) may change depending on the shape of the light emitting device 130. The TFT substrate may refer to a substrate on which transistors are disposed on the substrate 110. The TFT substrate may also include assembly wiring 120.

A plurality of light emitting devices 130 may be placed on a TFT substrate through a self-assembly method. A separate layer other than the second planarization layer 116 is used as a layer including a plurality of openings for self-assembling the plurality of light emitting devices 130 to the TFT substrate. The self-assembly method will be explained later.

The second planarization layer 116 is a layer formed after the light emitting device 130 is disposed and is disposed on the side of the light emitting device 130 to fix the light emitting device 130 to the TFT substrate.

The plurality of light emitting devices 130 are light emitting devices 130 that emit light by electric current. The plurality of light emitting devices 130 may include light emitting devices 130 that emit red light, green light, blue light, etc., and a combination of these may produce light of various colors, including white. For example, the light emitting device 130 may be a light emitting diode (LED) or a micro LED, but is not limited thereto.

The light emitting device 130 may include a first semiconductor layer 131, a light emitting layer 132, a second semiconductor layer 133, an auxiliary electrode 134, and a protective film 135.

The first semiconductor layer 131 may be disposed on the second passivation layer 115, and the second semiconductor layer 133 may be disposed on the first semiconductor layer 131. The first semiconductor layer 131 and the second semiconductor layer 133 may be layers formed by doping n-type and p-type impurities into a specific material. For example, the first semiconductor layer 131 and the second semiconductor layer 133 may be a layer doped with a p-type or n-type impurity in a material such as gallium nitride (GaN), indium aluminum phosphide (InAlP), or gallium arsenide (GaAs). In addition, the p-type impurity may be magnesium, zinc (Zn), beryllium (Be), etc., and the n-type impurity may be silicon (Si), germanium (Ge), tin (Sn), etc., but are not limited thereto.

Meanwhile, a portion of the first semiconductor layer 131 may be disposed to protrude outside the second semiconductor layer 133. For example, the upper surface of the first semiconductor layer 131 may be composed of a portion that overlaps the lower surface of the second semiconductor layer 133 and a portion disposed outside the lower surface of the second semiconductor layer 133. However, the size and shape of the first semiconductor layer 131 and the second semiconductor layer 133 may be changed in various ways, but are not limited thereto.

The light emitting layer 132 may be disposed between the first semiconductor layer 131 and the second semiconductor layer 133. The light emitting layer 132 may emit light by receiving holes and electrons from the first semiconductor layer 131 and the second semiconductor layer 133. The light emitting layer 132 may be made of a single-layer or multi-quantum well (MQW) structure, and may be made of, for example, indium gallium nitride (InGaN) or gallium nitride (GaN), but is not limited thereto.

The auxiliary electrode 134 may be disposed on the upper surface of the second semiconductor layer 133. The auxiliary electrode 134 is an electrode that electrically connects the second semiconductor layer 133 to a pixel electrode (PE), which will be described later. The auxiliary electrode 134 may be made of a transparent conductive material such as indium tin oxide (ITO) or indium zinc oxide (IZO), but is not limited thereto.

The protective film 135 may be disposed to surround a portion of the first semiconductor layer 131, the light emitting layer 132, and the second semiconductor layer 133. By forming a protective film 135 to protect the first semiconductor layer 131, the light emitting layer 132, and the second semiconductor layer 133 of the light emitting device 130, and short circuit defects may be prevented when forming the contact electrode (CE) and pixel electrode (PE), which will be described later. The protective film 135 may cover at least a side surface of the light emitting device 130 among the outer surfaces of the light emitting device 130. For example, The protective film 135 may be disposed to cover the side and top surface of the first semiconductor layer 131, the side surface of the light emitting layer 132, the top surface of the first semiconductor layer 131 protruding outward from the second semiconductor layer 133, and the auxiliary electrode 134. However, the protective film 135 may cover only the side surface of the second semiconductor layer 133 and the side surface of the light emitting layer 132, or may also cover a portion of the side surface of the first semiconductor layer 131, but is not limited thereto.

The contact electrode (CE) may be disposed inside the contact hole (156a). The contact electrode CE is an electrode that electrically connects the first assembly wiring 121 overlapping the contact hole 156a and the first semiconductor layer 131 of the light emitting device 130. In FIG. 3, the contact electrode (CE) is connected to the first assembly wiring 121, but is not limited to this, and the contact electrode CE may electrically connect the second assembly wiring 121 and the first semiconductor layer 131 of the light emitting device 130. After forming a contact hole exposing the first assembly wiring 121 in a portion of the second passivation layer 115 overlapping the first assembly wiring 121, a contact electrode (CE) is formed inside the contact hole (CH) formed in a portion of the second passivation layer 115 and the second planarization layer 116, so that the first semiconductor layer 131 of the light emitting device 130 and the first assembly wiring 121 may be electrically connected. The contact electrode (CE) may be in contact with the side of the second planarization layer 116 in the contact hole (CH), and the side surfaces of the first clad layer (121b) and the first semiconductor layer (131) of the first assembly wiring 121 exposed from the second passivation layer 115 in the contact hole (CH). Additionally, the contact electrode CE may be disposed on the top of the first semiconductor layer 131 protruding outside the second semiconductor layer 133, on the side of the light emitting layer 132, and on the side of the second semiconductor layer 133. In this case, short circuit defects that occur when the contact electrode (CE) and the second semiconductor layer 133 are electrically connected by the protective film 135 surrounding the light emitting layer 132 and the second semiconductor layer 133 may be prevented.

Meanwhile, the contact electrode (CE) may be made of a conductive material, such as copper (Cu), aluminum (Al), molybdenum (Mo), nickel (Ni), titanium (Ti), chromium (Cr), or an alloy thereof. At this time, when the contact electrode (CE) is formed of a conductive material with excellent reflective properties, among the light emitted from the light emitting device 130, light directed toward the side of the light emitting device 130 may be reflected toward the top of the light emitting device 130 by the contact electrode CE, and light efficiency may be improved.

The third planarization layer 117 may be disposed on the plurality of light emitting devices 130. The third planarization layer 117 may planarize the upper portion of the substrate 110 on which the plurality of light emitting devices 130 are disposed. The third planarization layer 117 may be composed of a single layer or a double layer, and may be made of, for example, an acryl-based organic material, but is not limited thereto.

The pixel electrode (PE) may be disposed on the third planarization layer 117. The pixel electrode (PE) is an electrode for electrically connecting the plurality of light emitting devices 130 and the connection electrode 123. The pixel electrode (PE) is electrically connected to the auxiliary electrode 134 of the light emitting device 130 through a contact hole formed in the third planarization layer 117, at the same time, pixel electrode (PE) may be electrically connected to the connection electrode 123 through the contact hole (CH) formed in the third planarization layer 117, the second planarization layer 116, and the second passivation layer 115.

Accordingly, the auxiliary electrode 134, the connection electrode 123, and the driving transistor (DTR) of the light emitting device 130 may be electrically connected through the pixel electrode (PE).

The black matrix BM may be disposed on the third planarization layer 117. The black matrix BM may be disposed between the plurality of sub-pixels SP on the third planarization layer 117. The black matrix (BM) may reduce color mixing between the plurality of sub-pixels (SP). The black matrix (BM) may be made of an opaque material, for example, black resin, but is not limited thereto.

A protective layer 118 is disposed on the pixel electrode (PE), the third planarization layer 117, and the black matrix (BM). The protective layer 118 is a layer to protect the structure below the protective layer 118, and may be composed of a single layer or multiple layers of translucent epoxy, silicon oxide (SiOx), or silicon nitride (SiNx), but is not limited thereto.

Hereinafter, the self-assembly process of the plurality of light emitting devices 130 will be described with reference to FIGS. 4A to 4I.

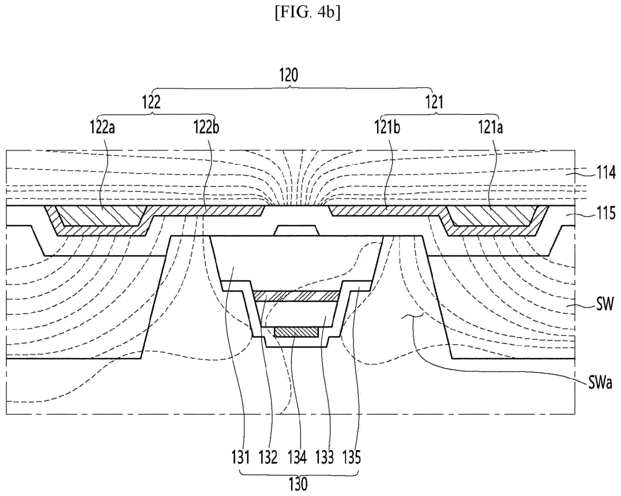

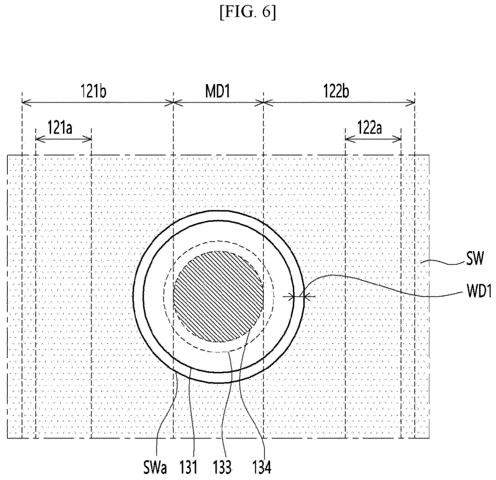

FIGS. 4A to 4C are process diagrams for explaining a manufacturing method of a display device according to an embodiment. FIGS. 4A to 4C are process diagrams for explaining a process of self-assembling a plurality of light emitting devices 130 into the opening SWa. And, FIG. 6 is a schematic enlarged plan view of FIG. 4B.

Referring to FIG. 4A, light emitting devices 130 are introduced into the chamber CB filled with the fluid WT. The fluid WT may include water, etc., and the chamber CB filled with the fluid WT may have an open top.

Next, the mother substrate 10 may be placed on the chamber CB filled with the light emitting device 130. The mother substrate 10 is a substrate composed of a plurality of substrates 110 forming the display device 100, when self-assembling the plurality of light emitting devices 130, the mother substrate 10 formed with the plurality of assembly wirings 120 and the barrier wall SW may be used.

The barrier wall SW is disposed on the second passivation layer 115 and includes a plurality of openings SWa in which each of the plurality of light emitting devices 130 is seated. A plurality of openings SWa may be disposed in each of the plurality of sub-pixels SP. For example, one opening SWa may be disposed in one sub-pixel (SP), but a plurality of openings SWa may be disposed in one sub-pixel (SP), but is not limited thereto.

The plurality of openings SWa are parts into which the plurality of light emitting devices 130 are inserted, and may also be referred to as pockets. The plurality of openings SWa may be formed to overlap the plurality of assembly wirings 120. One opening SWa may overlap the first assembly wiring 121 and the second assembly wiring 122 arranged adjacent to each other in one sub-pixel SP. For example, the first clad layer 121b of the first assembly wiring 121 and the second clad layer 121b of the second assembly wiring 122 may overlap the opening SWa.

The mother substrate 10 formed with the first assembly wiring 121 and the second assembly wiring 122 and the barrier wall SW is placed on the chamber CB or inserted into the chamber CB. At this time, the mother substrate 10 may be positioned so that the opening SWa of the barrier wall SW and the fluid WT face each other.

Next, the magnet MG may be placed on the mother substrate 10. The light emitting devices 130 that sink or float on the bottom of the chamber CB may move toward the mother substrate 10 by the magnetic force of the magnet MG.

At this time, the light emitting device 130 may include a magnetic material to move by a magnetic field. For example, the light emitting device 130 may include a ferromagnetic material such as iron, cobalt, or nickel.

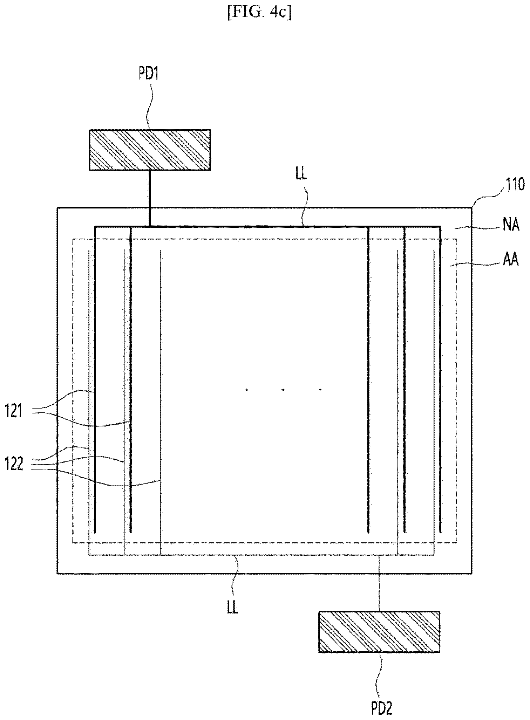

Next, referring to FIGS. 4b, 4c, and 6, the light emitting device 130 moved toward the barrier wall SW by the magnet MG may be self-assembled in the opening SWa by the electric field formed by the first assembly wiring 121 and the second assembly wiring 122.

An alternating voltage may be applied to the plurality of first assembly wirings 121 and the plurality of second assembly wirings 122 to generate an electric field. The light emitting device 130 may be dielectrically polarized by this electric field to have polarity. And the dielectrically polarized light emitting device 130 may be moved or fixed in a specific direction by dielectrophoresis (DEP), that is, an electric field. Accordingly, the plurality of light emitting devices 130 may be fixed within the opening SWa of the barrier wall SW using dielectrophoresis.

At this time, the same voltage is applied to the plurality of first assembly wirings 121 and the plurality of second assembly wirings 122 when driving the display device 100, but different voltages are applied when manufacturing the display device 100. To this end, when manufacturing the display device 100, the plurality of first assembly wirings 121 and the plurality of second assembly wirings 122 may be connected to different assembly pads and different voltages may be applied.

In relation to this, referring to FIG. 4C, when manufacturing the display device 100 and self-assembling the plurality of light emitting devices 130, the plurality of assembly wirings 120 may be connected to the assembly pad. Specifically, on the mother substrate 10, a plurality of substrates 110 forming the display device 100, a plurality of assembly pads, and a plurality of connection parts for the assembly wiring 120 may be disposed.

The plurality of assembly pads are pads for applying voltage to the plurality of assembly wirings 120, and may be electrically connected to a plurality of assembly wirings 120 disposed on each of the plurality of substrates 110 forming the mother substrate 10. A plurality of assembly pads may be formed on the mother substrate 10 outside the substrate 110 of the display device 100, and when the manufacturing process of the display device 100 is completed, the substrate 110 of the display device 100 and may be separated. For example, voltage is applied to the plurality of first assembly wirings 121 through the first assembly pad PD1, and voltage is applied to the plurality of second assembly wirings 122 through the second assembly pad PD2. So that, an electric field may be formed to align the plurality of light emitting devices 130.

At this time, the plurality of first assembly wirings 121 arranged on one substrate 110 are connected into one using the link wiring LL, and the plurality of second assembly wirings 122 are also connected into one, so that each of the plurality of first assembly wirings 121 and the plurality of second assembly wirings 122 may be easily connected to the assembly pad.

For example, the plurality of first assembly wirings 121 may be connected to one through the link wiring LL, and the plurality of second assembly wirings 122 may also be connected to one through the link wiring LL. In this case, each of the plurality of first assembly wirings 121 and the plurality of second assembly wirings 122 disposed on one substrate 110 is not individually connected to the assembly pad, but a plurality of first assembly wirings 121 and a link wire (LL) connecting each of the plurality of second assembly wirings 122 into one and the assembly pad are electrically connected, so that a voltage for self-assembly of the light emitting device 130 may be easily applied to the plurality of first assembly wirings 121 and the plurality of second assembly wirings 122.

Therefore, after placing the mother substrate 10 in the chamber (CB) into which the plurality of light emitting devices 130 are inserted, an electric field may be formed by applying an alternating voltage to a plurality of assembly wirings 120 through a plurality of assembly pads, and a plurality of light emitting devices 130 may be easily self-assembled into the opening SWa of the barrier wall SW.

Referring to FIG. 4b, the electric field formed in the plurality of assembly wirings 120 indicated by dotted lines may be confirmed. In particular, when the first assembly wiring 121 and the second assembly wiring 122 are arranged side by side on the same layer, the electric field is formed by focusing on the barrier wall SW rather than the inside of the opening SWa, so this may cause bias toward the barrier wall SW when the light emitting device 130 is seated in the opening SWa, resulting in assembly defects.

Meanwhile, when self-assembling a plurality of light emitting devices 130, the second passivation layer 115 may be formed throughout the opening SWa so that the first assembly wiring 121 and the second assembly wiring 122 are not exposed to the fluid WT. While self-assembling the light emitting device 130, the barrier wall SW may be formed to cover the first assembly wiring 121 and the second assembly wiring 122 overlapping the opening SWa. Accordingly, defects such as corrosion of the first assembly wiring 121 and the second assembly wiring 122 due to exposure to the fluid WT may be prevented.

Next, in a state in which the light emitting device 130 is fixed within the opening SWa using the electric field of the plurality of first assembly wirings 121 and the plurality of second assembly wirings 122, the mother substrate 10 may be flipped 180°. If the mother substrate 10 is turned over without applying voltage to the plurality of first assembly wirings 121 and the plurality of second assembly wirings 122, the plurality of light emitting devices 130 may escape from within the opening SWa. Therefore, with voltage applied to the plurality of first assembly wirings 121 and the plurality of second assembly wirings 122, the mother substrate 10 may be turned over and a subsequent process may be performed.

After the self-assembly process of the plurality of light emitting devices 130 is completed, the mother substrate 10 may be cut along the scribing line and separated into a plurality of substrates 110. Thereafter, through the link wire LL connecting the plurality of first assembly wirings 121 into one and the link wire LL connecting the plurality of second assembly wirings 122 into one,

The same voltage may be easily applied to the plurality of first assembly wirings 121 and the plurality of second assembly wirings 122.

For example, when driving the display device 100, by connecting the link wire LL connecting each of the plurality of first assembly wirings 121 and the plurality of second assembly wirings 122 into one and the driving IC, voltage may be applied to the plurality of first assembly wirings 121 and the plurality of second assembly wirings 122.

In the display device 100 according to the embodiment, at least some of the plurality of assembly wirings 120 for self-assembly of the plurality of light emitting devices 130 may be used as wiring for applying a low-potential power supply voltage to the plurality of light emitting devices 130. When manufacturing the display device 100, a plurality of light emitting devices 130 floating in the fluid WT may be moved adjacent to the mother substrate 10 using a magnetic field.

Then, different voltages may be applied to the plurality of first assembly wirings 121 and the plurality of second assembly wirings 122 to form an electric field, and the plurality of light emitting devices 130 may be self-assembled within the plurality of openings SWa by an electric field. At this time, instead of separately forming a wire that supplies a low-potential voltage and connecting it to the plurality of self-assembled light emitting devices 130, by electrically connecting the plurality of assembly wirings 120 and the first semiconductor layer 131 of the light emitting device 130 through the contact electrode (CE), when driving the display device 100, a plurality of assembly wirings 120 may be used as wiring for supplying low-potential voltage to a plurality of light emitting devices 130.

Therefore, in the display device 100 according to the embodiment, there is a technical effect in that the plurality of assembly wirings 120 may be used not only for self-assembly of the plurality of light emitting devices 130 but also as wiring for driving the plurality of light emitting devices 130.

In the display device 100 according to the embodiment, the plurality of assembly wirings 120 include clad layers 121b and 122b, and the second passivation layer 115 is formed throughout the opening SWa to form a plurality of Corrosion of the assembly wiring 120 or occurrence of short circuit defects may be reduced. The plurality of first assembly wirings 121 are composed of a first conductive layer 121a and a first clad layer 121b that surrounds the first conductive layer 121a and is more resistant to corrosion than the first conductive layer 121a, and the plurality of second assembly wirings 122 includes a second conductive layer 122a and a second clad layer 122b that surrounds the second conductive layer 122a and is more resistant to corrosion than the second conductive layer 122a.

When manufacturing the display device 100, the mother substrate 10 on which the plurality of assembly wirings 120 are formed is placed in the fluid WT to self-assemble the plurality of light emitting devices 130. In this case, the first conductive layer 121a and/or the second conductive layer 122a may be exposed in the fluid WT and the assembly wiring 120 may be corroded, which may cause a short circuit defect. Therefore, the first conductive layer 121a of the plurality of first assembly wirings 121 may be wrapped with the first clad layer 121b and the second passivation layer 115, and the second conductive layer 122a of the plurality of second assembly wirings 122 may be wrapped with the second clad layer 122b and the second passivation layer 115.

Accordingly, a plurality of assembly wiring 120 is formed in a structure including a first clad layer 121b and a second clad layer 122b, and during self-assembly of the plurality of light emitting devices 130, the second passivation layer 115 is formed to cover the plurality of assembly wirings 120 overlapping the opening SWa, the reliability of the plurality of assembly wirings 120 may be improved.

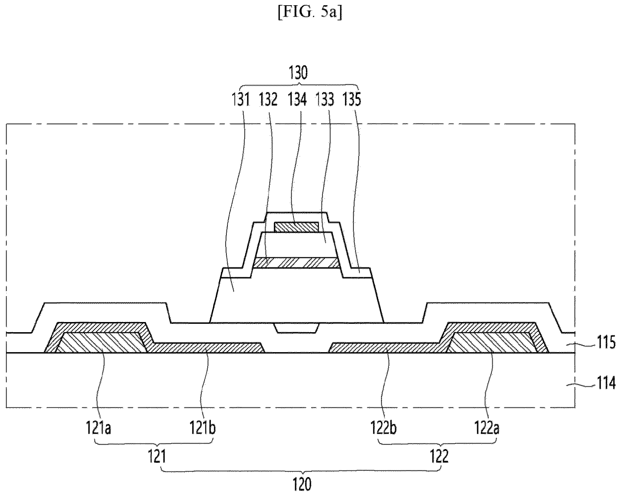

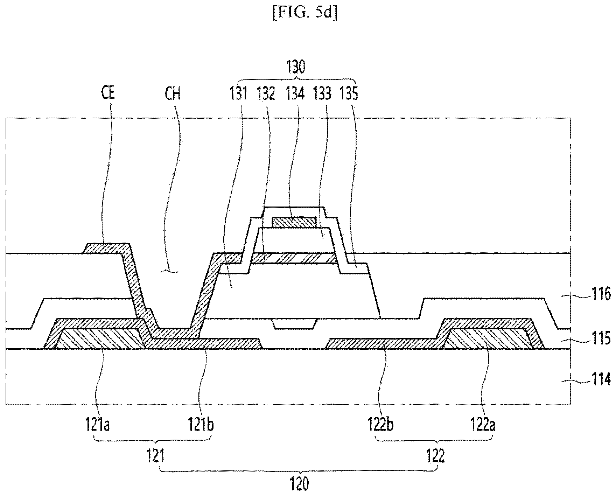

Meanwhile, after self-assembly of the plurality of light emitting devices 130 is completed, a contact electrode (CE) is to be formed to connect the plurality of first assembly wirings 121 and the plurality of second assembly wirings 122 with the first semiconductor layer 131 of the light emitting device 130. This will be described later with reference to FIGS. 5A to 5E.

FIGS. 5A to 5E are process diagrams for explaining the process of forming contact electrodes of a display device according to an embodiment. And, FIG. 6 is a schematic enlarged plan view of FIG. 4B.

As described above with reference to FIGS. 4A to 4C, the light emitting device 130 may be self-assembled inside the opening SWa. The light emitting device 130 may be seated on the second passivation layer 115 disposed inside the opening SWa.

Referring to FIG. 6, the separation distance WD1 between the barrier wall SW and the light emitting device 130 is about several *µ*m, and the width of the opening SWa may be small enough to generate capillary action. The light emitting device 130 may be seated and fixed inside the opening SWa by capillary action. The separation distance WD1 between the light emitting device 130 and the barrier wall SW may not be sufficient to form a contact electrode for connecting the light emitting device 130 and the assembly electrode 120. Therefore, referring to FIG. 5A, the barrier wall SW is removed to form a contact electrode.

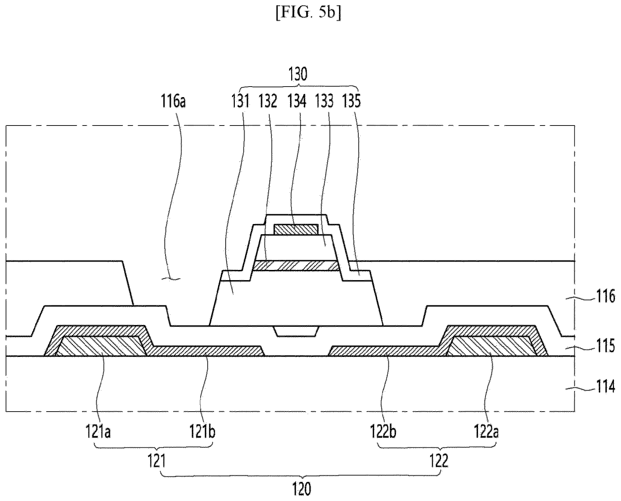

Referring to FIGS. 5B and 2, in order to fix the light emitting device 130, the second planarization layer 116 is formed to surround a portion of the light emitting device 130. The contact hole 116a included in the second planarization layer 116 surrounds half of the light emitting device 130 in FIG. 2, and the half may be formed in the same shape as the contact hole CH for disposing the contact electrode. The second planarization layer 116 may be formed with a thickness sufficient to completely cover the side surface of the first semiconductor layer 131 of the light emitting device 130 and partially cover the side surface of the protective film 135. The contact hole 116a of the second planarization layer 116 opens the side of the first semiconductor layer 131 of the light emitting device 130 and the top of the first clad layer 121b of the first assembly wiring 121.

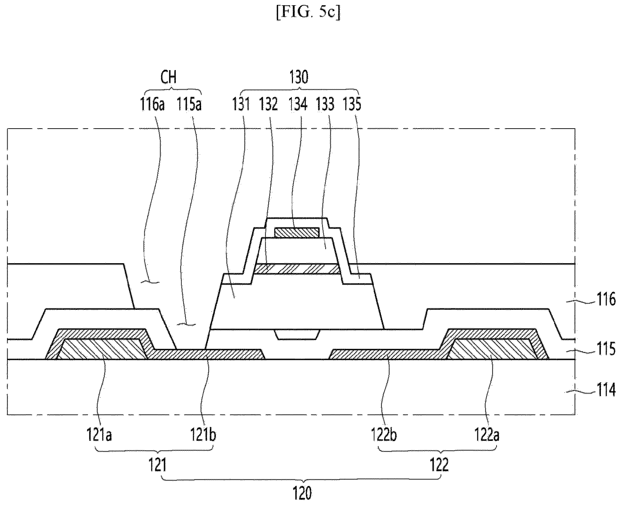

Referring to FIG. 5C, a contact hole 115a is formed in a portion of the second passivation layer 115 disposed outside the light emitting device 130 from the inside of the contact hole 116a of the second planarization layer 116. In the space between the side of the second planarization layer 116 and the light emitting device 130 in the contact hole 116a of the second planarization layer 116, a contact hole 115a exposing the first assembly wiring 121 may be formed in the second passivation layer 115. The first assembly wiring 121 may be exposed by forming a contact hole 115a in the second passivation layer 115 covering the first assembly wiring 121. The contact hole 115a of the second passivation layer 115 is formed inside the contact hole 116a of the second planarization layer 116 and may be formed in the same size and shape, but is not limited thereto. The contact hole 115a of the second passivation layer 115 and the contact hole 116a of the second planarization layer 116 may be collectively referred to as contact holes (CH).

Next, a contact electrode (CE) is formed on the entire surface of the substrate 110. Specifically, the contact electrode CE may be formed to cover the second planarization layer 116, the first assembly wiring 121, and the light emitting device 130. In particular, the contact electrode CE may be formed inside the contact hole CH to be in contact with the upper surface of the first assembly wiring 121 exposed through the contact hole 115a of the second passivation layer 115. The contact electrode (CE) may be made of a conductive material such as copper (Cu), aluminum (Al), molybdenum (Mo), nickel (Ni), titanium (Ti), chromium (Cr) or an alloy thereof, or ITO (Indium Tin Oxide) or IZO (Indium Zinc Oxide), etc.

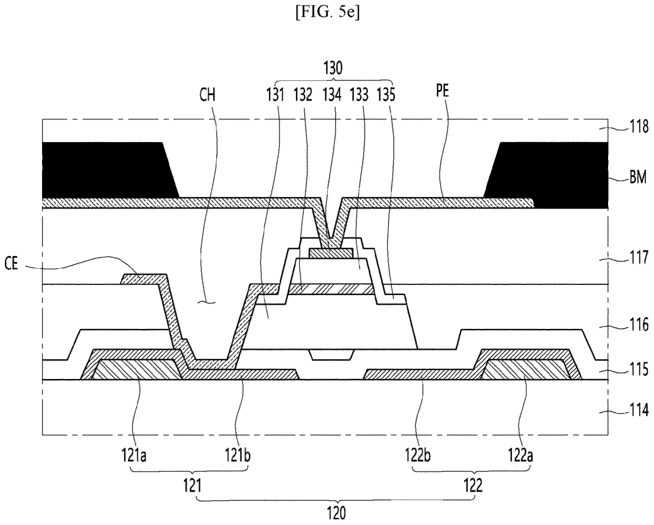

Next, referring to FIG. 5E, as a third planarization layer 117, a pixel electrode (PE), a black matrix (BM), and a protective layer 118 are sequentially formed on the second planarization layer 116, the contact electrode (CE), and the light emitting device 130, the manufacturing process of the display device 100 may be completed.

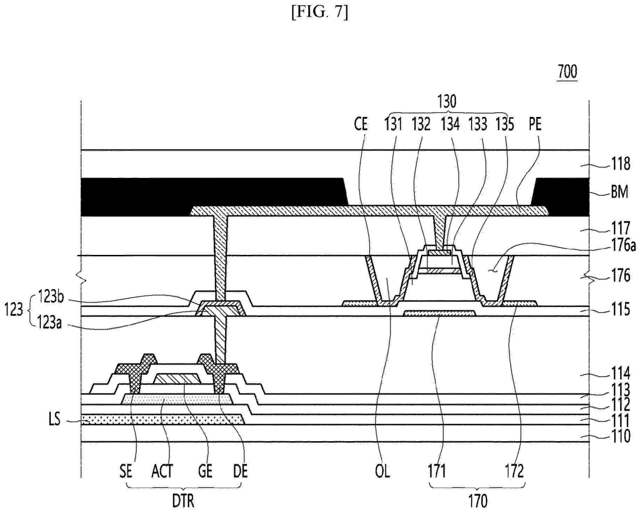

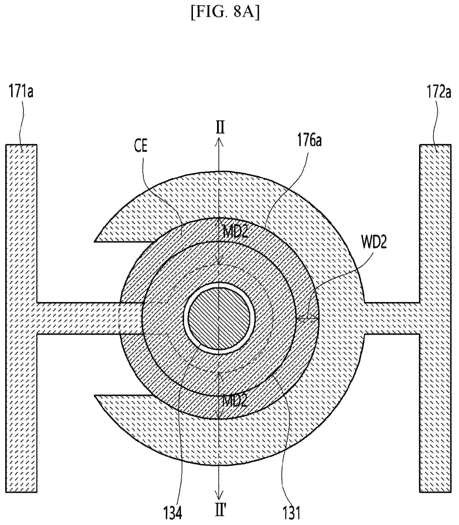

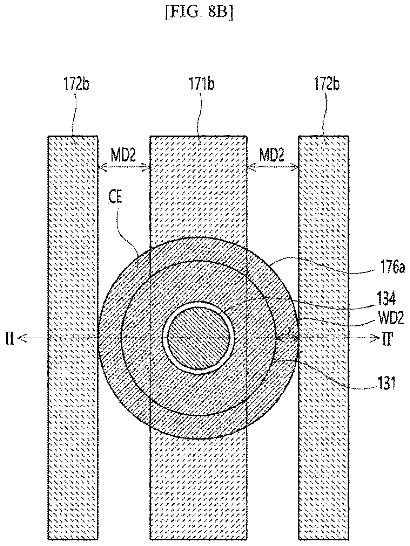

FIG. 7 is a cross-sectional view of a display device according to a second embodiment. 8A and 8B are schematic enlarged plan views of a display device according to a second embodiment. Specifically, the cross-sectional view of the light emitting device 130 and the assembly wiring 170 shown in FIG. 7 corresponds to the cross-section taken along line II-II' of FIGS. 8A and 8B.

The second embodiment may adopt the features of the first embodiment. For example, the second embodiment has the technical effect of connecting a contact electrode to the assembly wiring and connecting the contact electrode to the side of the first semiconductor layer, allowing the assembly wiring to be used as a driving wiring for a light emitting device.

Referring to FIGS. 7, 8A, and 8B, a plurality of first assembly wirings 171 are disposed on the first planarization layer 114. The plurality of first assembly wirings 171 may be disposed in the center of the opening 176a and formed of the same material as the first connection layer 123a or the second connection layer 123b. And the plurality of second assembly wirings 172 may be disposed outside the opening 176a on the second passivation layer 115 and may be formed of the same material as the first connection layer 123a or the second connection layer 123b. The second assembly wiring 172 may be symmetrically disposed about the first assembly wiring 171 and may be formed of the same material as the first connection layer 123a or the second connection layer 234b. Additionally, since the first assembly wiring 171 and the second assembly wiring 172 are insulated by the second passivation layer 115, they may be formed of the same material.

In addition, since the first assembly wiring 171 and the second assembly wiring 172 are insulated by the second passivation layer 115, the second separation distance MD2 between the first assembly wiring 171 and the second assembly wiring 172 may be smaller than the first separation distance MD 1 between the first assembly wiring 121 and the second assembly wiring 122 of the display device 100 according to the embodiment.

Therefore, in the display device 700 according to the second embodiment, since the second separation distance MD2 between the first assembly wiring 171 and the second assembly wiring 172 may be precisely narrowed, there is a technical effect of improving the assembly rate of the light emitting device 130.

A second planarization layer 176 may be disposed on the plurality of second assembly wirings 172. The second planarization layer 176 may be composed of a single layer or a double layer, and may be made of, for example, an acryl-based organic material, but is not limited thereto.

The second planarization layer 176 includes a plurality of openings 176a in which each of the plurality of light emitting devices 130 is seated. A plurality of openings 176a may be disposed in each of the plurality of sub-pixels SP. For example, one opening 176a may be disposed in one sub-pixel SP, but a plurality of openings 176a may be disposed in one sub-pixel SP, but the present invention is not limited thereto.

The plurality of openings 176a are parts into which the plurality of light emitting devices 130 are inserted, and may also be referred to as pockets. The plurality of openings 176a may be formed to overlap the first assembly wiring 171. In addition, the second planarization layer 176 overlaps the second assembly wiring 172 and may be formed so that the side surface of the second assembly wiring 172 is exposed to the opening 176a on the side of the second planarization layer 176. The side surface of the second planarization layer 176 and the side surface of the second assembly wiring 172 may be formed parallel to each other. By exposing the second assembly wiring 172 to the opening 176a, the second assembly wiring 172 and the light emitting device 130 may be easily connected.

A contact electrode (CE) is disposed inside the opening 176a. The contact electrode CE is an electrode that electrically connects the second assembly wiring 172 overlapping the second planarization layer 176 with the first semiconductor layer 131 of the light emitting device 130.

The contact electrode CE may contact the side of the second planarization layer 176, the second assembly wiring 172, and the side of the first semiconductor layer 131 exposed from the second planarization layer 176 at the opening 176a. Additionally, the contact electrode CE may be disposed on the top of the first semiconductor layer 131 protruding outward from the second semiconductor layer 133, on the side of the light emitting layer 132, and on the side of the second semiconductor layer 133. in this case, a technical effect that may prevent short circuit defects that occur when the contact electrode CE and the second semiconductor layer 133 are electrically connected by the protective film 135 surrounding the light emitting layer 132 and the second semiconductor layer 133.

Meanwhile, the contact electrode CE may be made of a conductive material, such as copper (Cu), aluminum (Al), molybdenum (Mo), nickel (Ni), titanium (Ti), chromium (Cr), or an alloy thereof. And, when the contact electrode CE is formed of a conductive material with excellent reflective properties, among the light emitted from the light emitting device 130, light directed toward the side of the light emitting device 130 may be reflected to the top of the light emitting device 130 by the contact electrode CE, and there is a technical effect of improving light efficiency.

Referring to FIG. 8A, the first assembly wiring 171a may include a first part shared with the sub-pixels SP arranged in the column direction and a second part branched from the first part to each sub-pixel SP. The first part may be in the shape of a stripe extending in the column direction, and the second part may be in the shape of a circle. The second part is not limited to the shape of a circle, and may change depending on the shape of the opening 176a or the shape of the light emitting device 130. The second portion may be disposed centrally within the opening 176a. Additionally, the second assembly wiring 172a may include a third portion shared with the sub-pixels SP arranged in the column direction and a fourth portion branched from the third wiring to each sub-pixel SP. The third part may be shaped like a stripe extending in the column direction like the first part, and the fourth part may be shaped like a donut surrounding the second part. The fourth part is not limited to a donut shape and may change depending on the shape of the second part. The fourth portion overlaps the second planarization layer 176 and is exposed to the opening 176a by the side surface of the second planarization layer 176.

Referring to FIG. 8B, the first assembly wiring 171b and the second assembly wiring 172b are each shared with the sub-pixels SP arranged in the column direction and may have a stripe shape formed long in the column direction. The first assembly wiring 171b is disposed in the center of the opening 176a, the second assembly wiring 172b may be arranged on both sides of the first assembly wiring 171b in the row direction with the first assembly wiring 171b as the center. The first assembly wiring 171b overlaps the opening 176a, the second assembly wiring 171 overlaps the second planarization layer 176 and is exposed to the opening 176a by the side surface of the second planarization layer 176.

Therefore, in the display device 700 according to the second embodiment, by placing the first assembly electrode 171 and the second assembly electrode 172 in different layers, by narrowing the distance between the first assembly electrode 171 and the second assembly electrode 172, the assembly rate of the light emitting device 130 may be improved. Additionally, by exposing the second assembly electrode 172 to the opening 176a, the contact electrode CE may be easily connected to the light emitting device 130 and the second assembly wiring 172.

Meanwhile, the organic material OL1 may be disposed on the contact electrode CE disposed in the opening 176a. The organic material (OL1) protects the contact electrode (CE) on the contact electrode (CE) in order to control the position where the contact electrode (CE) is placed. The organic material (OL1) will be described in detail in the manufacturing method of the display device that will be described later.

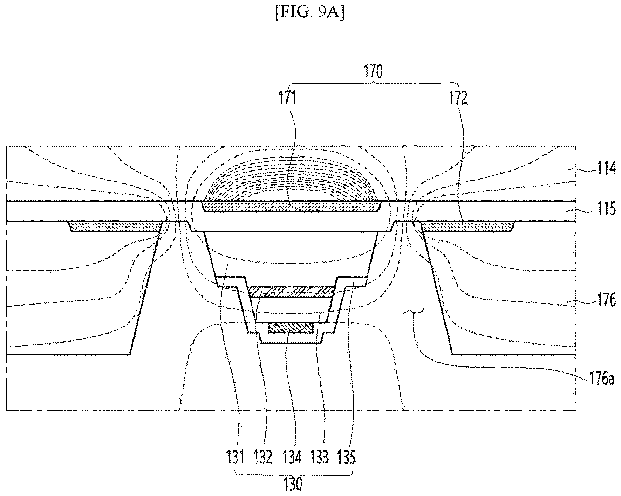

FIGS. 9A to 9E are process charts for explaining the manufacturing method of the display device according to the second embodiment. The process of self-assembling the plurality of light emitting devices 130 of FIGS. 4A and 4B into the opening 176a may be applied in the same manner.

Referring to FIG. 9a, on the mother substrate 10, a second planarization layer 176 including a plurality of assembly wirings 170 and an opening 176a for self-assembly of the plurality of light emitting devices 130 on the substrate 110 is formed, the light emitting device 130 moved toward the second planarization layer 176 by the magnet MG may be self-assembled in the opening 176a by the electric field formed by the first assembly wiring 171 and the second assembly wiring 172.

Referring to FIG. 9a, on the mother substrate 10, a second planarization layer 176 including a plurality of assembly wirings 170 and an opening 176a for self-assembly of the plurality of light emitting devices 130 on the substrate 110 is formed, the light emitting device 130 moved toward the second planarization layer 176 by the magnet MG may be self-assembled in the opening 176a by the electric field formed by the first assembly wiring 171 and the second assembly wiring 172.

An alternating voltage may be applied to the plurality of first assembly wirings 171 and the plurality of second assembly wirings 172 to generate an electric field. The light emitting device 130 may be dielectrically polarized by this electric field to have polarity. And the dielectrically polarized light emitting device 130 may be moved or fixed in a specific direction by dielectrophoresis (DEP), that is, an electric field. Accordingly, the plurality of light emitting devices 130 may be fixed within the opening 176a of the second planarization layer 176 using dielectrophoresis.

An electric field may be formed by applying an alternating voltage to each of the first assembly wiring 171 and the second assembly wiring 172 through a plurality of assembly pads. The dotted line shown in FIG. 9A represents the electric field formed in the assembly wiring 170. When the first assembly wiring 171 and the second assembly wiring 172 are arranged in different layers and the second assembly wiring 172 is arranged symmetrically with respect to the first assembly wiring 171, the electric field being focused on the second planarization layer 176 may be reduced and concentrated around the first assembly wiring 171. Accordingly, there is a technical effect of improving the assembly rate by reducing assembly defects that are biased toward the second planarization layer 176 when the light emitting device 130 is seated in the opening 176a.

In the display device 700 according to the second embodiment, at least some of the plurality of assembly wirings 170 for self-assembly of the plurality of light emitting devices 130 may be used as wiring for applying a low-potential power supply voltage to the plurality of light emitting devices 130. When manufacturing the display device 700, a plurality of light emitting devices 130 floating in the fluid WT may be moved adjacent to the mother substrate 10 using a magnetic field. Subsequently, different voltages may be applied to the plurality of first assembly wirings 171 and the plurality of second assembly wirings 172 to form an electric field, the plurality of light emitting devices 130 may be self-assembled within the plurality of openings 176a by an electric field. At this time, instead of separately forming a wire that supplies a low-potential voltage and connecting it to the plurality of self-assembled light emitting devices 130, by electrically connecting the plurality of assembly wirings 120 and the first semiconductor layer 131 of the light emitting device 130 through the contact electrode (CE), when driving the display device 100, a plurality of assembly wirings 120 may be used as wiring for supplying low-potential voltage to a plurality of light emitting devices 130.

Therefore, in the display device 700 according to the second embodiment, there is a technical effect in that the plurality of assembly wirings 170 may be used not only for self-assembly of the plurality of light emitting devices 130 but also as wiring for driving the plurality of light emitting devices 130.

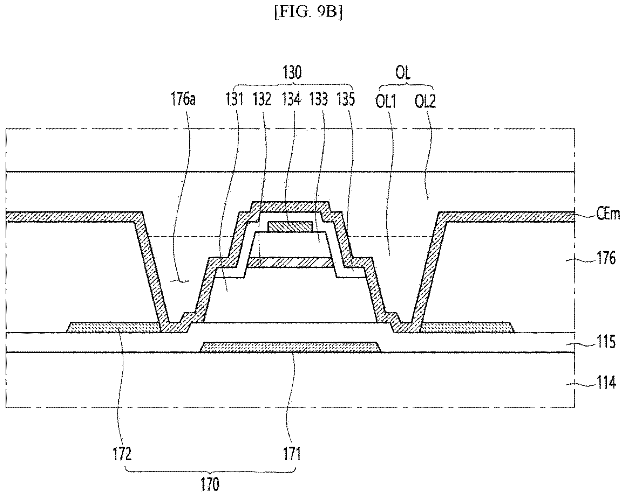

Meanwhile, after self-assembly of the plurality of light emitting devices 130 is completed, a contact electrode (CE) is to be formed to connect the plurality of first assembly wirings 171 and the plurality of second assembly wirings 172 with the first semiconductor layer 131 of the light emitting device 130. At this time, the contact electrode (CE) may be self-aligned with the first semiconductor layer 131 of the light emitting device 130. That is, the contact electrode (CE) may be formed by self-aligning with the first semiconductor layer 131 of the light emitting device 130, and it is possible to prevent a short circuit between the contact electrode (CE), the auxiliary electrode 134, and the pixel electrode (PE) due to misalignment of the contact electrode (CE). This will be described later with reference to FIGS. 9B to 9E.

Referring to FIG. 9B, the light emitting device 130 may be seated on the second passivation layer 176 disposed inside the opening 176a. A conductive layer (CEm) and an organic layer (OL) are sequentially formed on the entire surface of the substrate 110. Specifically, a conductive layer (CEm) may be formed to cover the second planarization layer 176, the second assembly wiring 172, and the light emitting device 130, and an organic layer (OL) may be formed on the conductive layer (CEm). In particular, the conductive layer (CEm) may be formed inside the opening 176a to contact the side of the second assembly wiring 172 exposed on the side of the second planarization layer 176. The conductive layer (CEm) may be made of conductive materials such as copper (Cu), aluminum (Al), molybdenum (Mo), nickel (Ni), titanium (Ti), chromium (Cr) or alloys thereof, ITO (Indium Tin Oxide) or IZO (Indium Zinc Oxide), etc., and the organic layer OL may be made of an organic material such as photoresist.

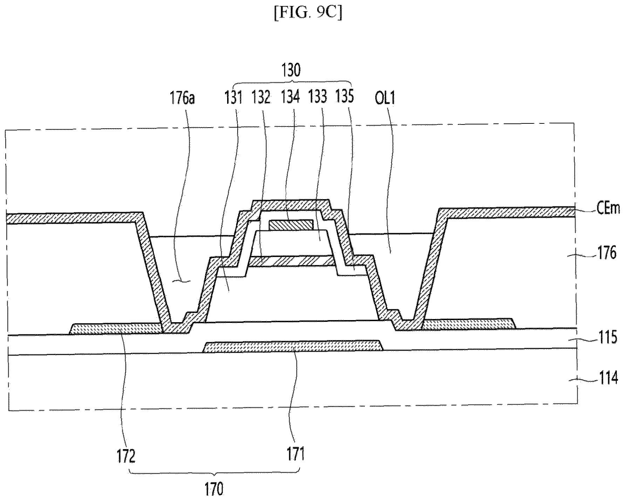

Next, referring to FIG. 9C, an ashing process is performed on the organic layer OL to remove the second portion OL2 of the organic layer OL. The ashing process is a process of decomposing or removing organic materials such as photoresist or polymer using plasma containing oxygen.

Through the ashing process, only the second part OL2 of the organic layer OL may be removed and the first part OL1 of the organic layer OL may be left. For example, during the ashing process, the second part OL2 of the organic layer OL is removed, so that only the first portion OL1 of the organic layer OL surrounding a portion of the side surface of the light emitting device 130 inside the opening 176a may remain on the substrate 110.

In the specification, for convenience of explanation, the lower part of the organic layer OL that is not removed during the ashing process is defined as the first part OL1, and the upper portion of the organic layer OL removed during the ashing process is referred to as the second part OL2, but the embodiment is not limited thereto.

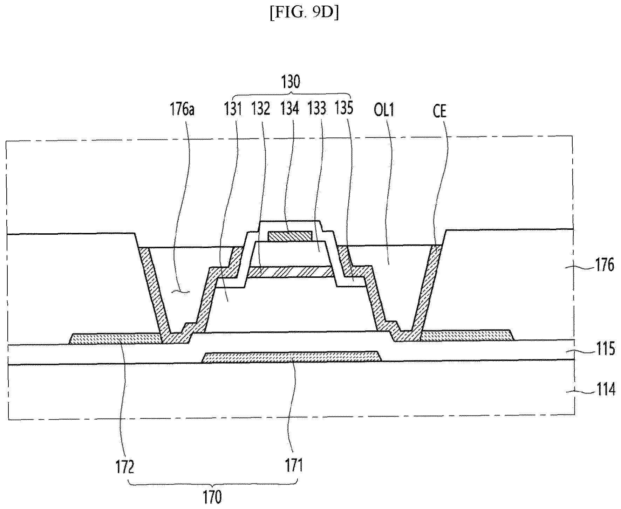

Next, referring to FIG. 9D, a portion of the conductive layer (CEm) exposed from the organic layer OL is removed through an etching process. As the second portion OL2 of the organic layer OL is removed through the ashing process, a portion of the conductive layer CEm may be exposed to the outside from the second portion OL2 of the organic layer OL. For example, a portion of the conductive layer (CEm) covering the top and side surfaces of the second planarization layer 176, the top side of the opening 176a, and the top and side portions of the optical device 130 may be exposed from the organic layer OL. And through the etching process, a portion of the conductive layer (CEm) covering the top side of the second planarization layer 176, the top side of the opening 176a, and the top and side portions of the light emitting device 130 is removed, so that only the conductive layer (CEm) disposed under the first portion OL1 of the organic layer OL may remain.

In other words, the organic layer (OL) may function as a mask when etching the conductive layer (CEm), and a portion of the conductive layer (CEm) covered with the organic layer (OL) may not be removed in the etching process. Accordingly, only the conductive layer (CEm) corresponding to the first portion (OL1) of the organic layer (OL) remains on the substrate 110 to form the contact electrode (CE).

And the first part OL1 of the organic layer OL, which functions as a mask, is arranged to surround at least the first semiconductor layer 131 of the light emitting device 130, the conductive layer (CEm) in contact with the side surface of the first semiconductor layer 131 may remain on the substrate 110 without being removed during the etching process. The top surface of the first portion OL1 may be disposed at or below the top surface of the second semiconductor layer 133. Accordingly, a contact electrode (CE) may be formed in contact with the side surface of the first semiconductor layer 131.

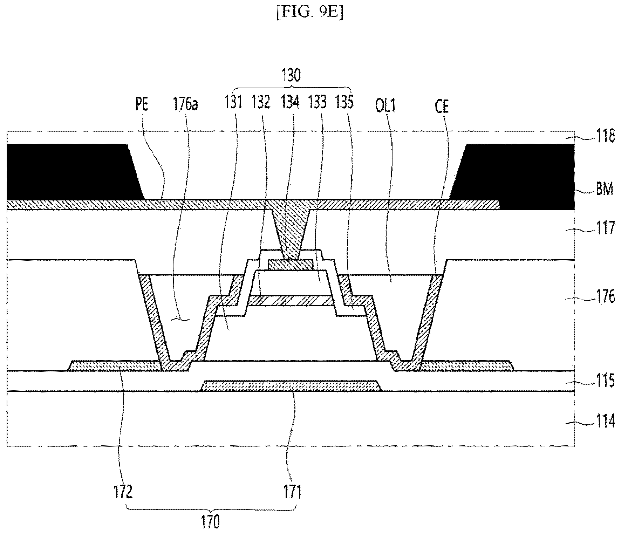

Next, referring to FIG. 9e, after forming the contact electrode (CE), as a third planarization layer 117, a pixel electrode (PE), and a black matrix (BM) and protective layer 118 are sequentially formed, the manufacturing process of the display device 700 may be completed.

The display device 700 according to the second embodiment as the technical effect of self-aligning the first semiconductor layer 131 and the contact electrode (CE) of the light emitting device 130 through an ashing process of the organic layer (OL). First, a conductive layer (CEm) and an organic layer (OL) for forming a contact electrode (CE) may be formed on the entire surface of the substrate 110 on the light emitting device 130. Then, an ashing process may be performed on the organic layer OL to remove the second part OL2 of the organic layer OL, leaving only the first part OL1 located inside the opening 176a, and the conductive layer (CEm) covering the auxiliary electrode 134 and the second semiconductor layer 133 of the light emitting device 130 may be exposed. Then, an etching process was performed to remove a portion of the conductive layer (CEm) exposed from the organic layer (OL), that is, a portion of the conductive layer (CEm) covering the auxiliary electrode 134 and the second semiconductor layer 133 of the light emitting device 130 may be removed, a portion of the conductive layer (CEm) covered with the first portion (OL1) of the organic layer (OL) remains without being removed, a contact electrode (CE) may be formed in contact with the side of the first semiconductor layer 131 and the second assembly wiring 122. Therefore, the ashing process is performed so that only the organic layer OL surrounding the first semiconductor layer 131 of the light emitting device 130 remains inside the opening 176a, the remainder may be etched, leaving only the conductive layer (CEm) in contact with the side of the first semiconductor layer 131, a contact electrode (CE) that electrically connects the first semiconductor layer 131 of the light emitting device 130 and the plurality of assembly wirings 170 may be easily formed.

Referring to FIG. 8a and FIG. 8b, the separation distance WD2 between the second planarization layer 176 and the light emitting device 130 is about several µm, and the width of the opening 176a is maintained small enough to generate capillary action, the light emitting device 130 may be seated and fixed inside the opening 176a by capillary action. For example, when the assembly electrode 170 is disposed below the second passivation layer 115, since a contact hole is to be formed in the second passivation layer 115 to connect the light emitting device 130 and the assembly electrode 170, the separation distance WD2 between the light emitting device 130 and the second planarization layer 176 is not sufficient to form a contact electrode for connecting the light emitting device 130 and the assembly electrode 170. However, according to the display device according to the second embodiment, the second assembly wirings 172a and 172b are exposed from the side of the second planarization layer 176 to the opening 176a to form the contact electrode CE without an additional process.

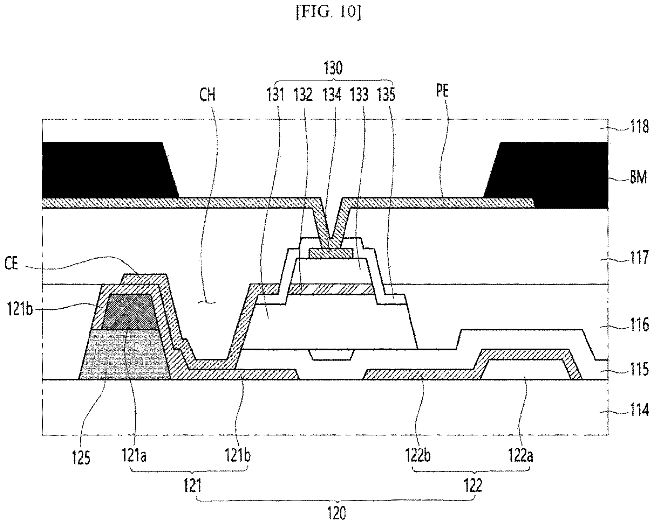

FIG. 10 is a cross-sectional view of a display device according to a third embodiment. The third embodiment may adopt the technical features of the first embodiment. For example, the first semiconductor layer 131 of the light emitting device 130 and the first assembly wiring 121 may be electrically connected by forming a contact electrode (CE) inside the contact hole (CH).

Referring to FIG. 10, a regular taper-shaped structure 125 may be disposed on the first planarization layer 114. In FIG. 10, the shape of the structure 125 is shown as a regular taper shape, but it is not limited to this.

Additionally, the first conductive layer 121a may be disposed on the structure 125. The first clad layer 121b may be disposed on the first conductive layer 121a. In detail, the first clad layer is in contact with the first conductive layer 121a and may be disposed to extend onto the first planarization layer 114 along the sidewall of the opening.

Then, a contact electrode (CE) may be placed inside the opening. The contact electrode (CE) may be disposed along the sidewall of the opening to increase the contact area with the first clad layer 121b. The contact electrode (CE) may electrically connect the assembly wiring 120 to the first semiconductor layer 131 of the light emitting device 130.

Therefore, in the third embodiment, as the contact area between the contact electrode (CE) and the first clad layer (121b) increases, there is a technical effect that the amount of current flowing from the assembly wiring 120 to the contact electrode (CE) increases and the resistance decreases. Accordingly, there is a technical effect in that the light emitting device 130 may be driven even at a low voltage.

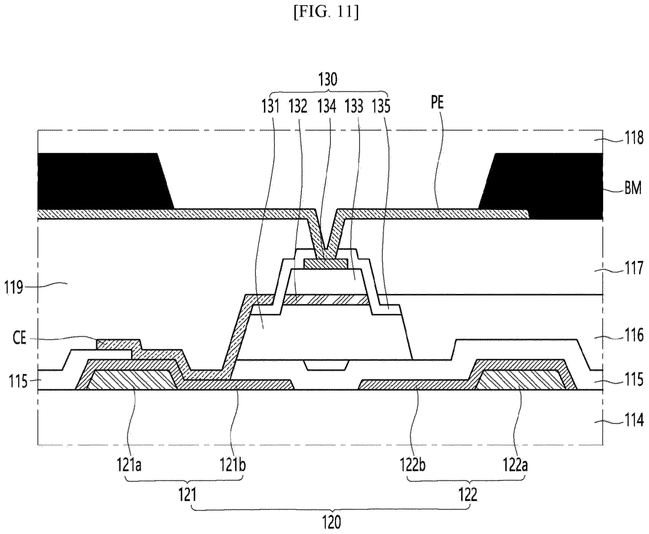

FIG. 11 is a cross-sectional view of a display device according to the fourth embodiment. The fourth embodiment may adopt the technical features of the first embodiment. For example, a contact electrode (CE) may be formed on the side of the semiconductor light emitting device 130 to electrically connect the first semiconductor layer 131 of the light emitting device 130 and the first assembly wiring 121.

Referring to FIG. 11, a first conductive layer 121a may be disposed on the first planarization layer 114, and a first clad layer 121b may be disposed on the first conductive layer 121a. Additionally, the second passivation layer 115 may be disposed to cover a portion of the first clad layer 121b.

Additionally, a contact electrode (CE) may be disposed on the side of the semiconductor light emitting device 130. In detail, a contact electrode (CE) may be disposed on the side of the first semiconductor layer 131 of the semiconductor light emitting device 130, the contact electrode (CE) may extend along one side of the first clad layer (121b), and a portion of the second passivation layer 115 disposed on the first clad layer 121b may be covered.

Accordingly, in the fourth embodiment, the first semiconductor layer 131 of the semiconductor light emitting device 130 and the first assembly wiring 121 may be electrically connected through the contact electrode (CE).

Meanwhile, the side wall of the assembly hole where the semiconductor light emitting device 130 is assembled may be removed after the semiconductor light emitting device is assembled. For example, the side walls of the assembly hole are made of PR material and may be removed through an etching process. Next, a contact electrode (CE) may be formed on one side of the assembled semiconductor light emitting device 130. The contact electrode (CE) may extend along one side of the first clad layer 121b and cover a portion of the second passivation layer 115 disposed on the first clad layer 121b.

Subsequently, a fourth planarization layer 119 may be formed on the contact electrode (CE) and the second passivation layer 115. Accordingly, the fourth planarization layer 119 may be interposed between the contact electrode (CE) and the pixel electrode (PE). Accordingly, the fourth embodiment has the technical effect of preventing electrical short-circuit defects and improving the reliability of the display device by ensuring a sufficient gap between the contact electrode (CE) and the pixel electrode (PE).

In the fourth embodiment, the case where there is only one contact electrode connected to the side of the semiconductor light emitting device was described, but it may also be applied when contact electrodes are connected to both sides of the semiconductor light emitting device.

A display device including a semiconductor light emitting device according to an embodiment has the technical effect of being able to utilize the wiring for self-assembly of the light emitting device as a wiring for driving the light emitting device.

In addition, the embodiment has the technical effect of reducing short circuit defects in the assembly wiring by arranging the assembly wiring in different layers and improving the assembly rate of the light emitting device by finely adjusting the spacing between the assembly wiring.

In addition, the embodiment has the technical effect of improving assembly defects caused by the light emitting device being biased to one side by arranging it in a symmetrical structure using assembly wiring.

In addition, the embodiment has the technical effect of reducing the process of forming a passivation layer contact hole for connecting the first semiconductor layer of the light emitting device and the assembly wiring by forming the assembly wiring to be exposed to the side of the barrier wall.

In addition, the embodiment has the technical effect of increasing the amount of current by increasing the contact area of the contact electrode and the assembly wiring, and enabling the light emitting device to be driven even at a low voltage.

Additionally, the embodiment has the technical effect of preventing electrical short circuit between the contact electrode and the pixel electrode.

The above detailed description should not be construed as restrictive in any respect and should be considered illustrative. The scope of the embodiments should be determined by reasonable interpretation of the appended claims, and all changes within the equivalent scope of the embodiments are included in the scope of the embodiments.

### [Explanation of cited reference]

100, 700: Display device
110: substrate, 111: buffer layer
112: Gate insulating layer, 113: First passivation layer
114: first planarization layer, 115: second passivation layer
116, 176: second planarization layer 116a, 176a: opening
117: third planarization layer 118: protective layer
119: Fourth planarization layer 120, 170: Assembly wiring 121, 171: First assembly wiring
121a: first conductive layer, 121b: first clad layer
122, 172: second assembly wiring, 122a: second conductive layer
122b: second clad layer, 123: connection electrode
123a: first connection layer, 123b: second connection layer
125: Structure, 130: Light emitting device
131: first semiconductor layer, 132: light emitting layer
133: second semiconductor layer, 134: auxiliary electrode
135: Shield, AA: Display area
NA: Non-display area, SP: Sub pixel
DTR: Driving transistor, ACT: Active layer
GE: Gate electrode, SE: Source electrode
DE: Drain electrode, CH: Contact hole
CE: Contact electrode, PE: Pixel electrode
BM: Black Matrix, 10: Ledger Board
CB: Chamber, WT: Fluid
MG: Magnet, PD 1: First assembly pad
PD2: Second assembly pad, LL: Link wiring
CEm: conductive layer, OL: organic layer
OL1: Part 1 OL2: Part 2
SW: barrier wall

### [Industrial Applicability]

The embodiment may be adopted in the field of displays that display images or information.

The embodiment may be adopted in the field of displays that display images or information using semiconductor light emitting devices.

The embodiment may be adopted in the field of displays that display images or information using micro- or nano-level semiconductor light emitting devices.

## Claims

1. A display device including a semiconductor light emitting device comprising:
a substrate;
a first assembly wiring and a second assembly wiring spaced apart from each other on the substrate;
a first insulating layer disposed between the first assembly wiring and the second assembly wiring;
a first planarization layer disposed on the second assembly wiring and comprising an opening overlapping the second assembly wiring;
a light emitting device disposed inside the opening and comprising a first semiconductor layer and a second semiconductor layer on the first semiconductor layer, and
a contact electrode electrically connecting the second assembly wiring and the first semiconductor layer,
wherein the contact electrode is in contact with the second assembly wiring overlapping a side of the first semiconductor layer and the first planarization layer.

2. The display device including the semiconductor light emitting device according to claim 1, wherein the light emitting device is configured to overlap the first assembly wiring.

3. The display device including the semiconductor light emitting device according to claim 1, wherein the first assembly wiring and the second assembly wiring are made of the same material.

4. The display device including the semiconductor light emitting device according to claim 1, wherein an upper portion of the second assembly wiring is in contact with the first planarization layer, and the side surface of the second assembly wiring is in contact with the contact electrode.

5. The display device including the semiconductor light emitting device according to claim 4, wherein the contact electrode is disposed on a side surface of the first planarization layer and a side surface of the second assembly wiring inside the opening.

6. The display device including the semiconductor light emitting device according to claim 5, further comprising a second planarization layer disposed on the first planarization layer, and
wherein the light emitting device further comprises an auxiliary electrode connected to the second semiconductor layer and exposed by the second planarization layer.

7. The display device including the semiconductor light emitting device according to claim 1, wherein the first assembly wiring and the second assembly wiring comprise a stripe shape, and
wherein the second assembly wiring is disposed on both sides of the first assembly wiring in the center.

8. The display device including the semiconductor light emitting device according to claim 1, wherein the first assembly wiring comprises a first part in the shape of a stripe and a second part branched from the first part and comprising the shape of a circle, and
wherein the second assembly wiring comprises a stripe-shaped third part and a donut-shaped fourth part branched from the third part and surrounding a portion of the second part.

9. A display device including a semiconductor light emitting device comprising:
a substrate;
a first assembly wiring and a second assembly wiring alternately arranged on the substrate and spaced apart from each other;
a planarization layer disposed on the second assembly wiring and having an opening;
a light emitting device disposed inside the opening and comprising a first semiconductor layer and a second semiconductor layer on the first semiconductor layer; and
a contact electrode connecting the second assembly wiring and the first semiconductor layer of the light emitting device within the opening,
wherein the first assembly wiring is configured to overlap the light emitting device, and
wherein a side surface of the second assembly wiring is disposed parallel to a side surface of the planarization layer.

10. The display device including the semiconductor light emitting device according to claim 9, further comprising a contact electrode disposed in contact with the side of the planarization layer, the second assembly wiring, and the first semiconductor layer.

11. The display device including the semiconductor light emitting device according to claim 9, further comprising an insulating layer disposed on the first assembly wiring to insulate the first assembly wiring and the second assembly wiring.

12. The display device including the semiconductor light emitting device according to claim 9, wherein the second assembly wiring is spaced apart from the first assembly wiring at a predetermined distance.

13. The display device including the semiconductor light emitting device according to claim 9, wherein the first assembly wiring comprises a first part and a second part of different shapes, and
wherein the second assembly wiring comprises a third part and a fourth part of different shapes.

14. The display device including the semiconductor light emitting device according to claim 13, wherein the first part and the third part comprise the same shape, and the second part and the fourth part comprise different shapes.

15. The display device including the semiconductor light emitting device according to claim 14, wherein the fourth part is configured to surround a portion of the second part.

16. The display device including the semiconductor light emitting device according to claim 13, wherein the first part and the third part are configured to overlap with the opening, and the second part and the fourth part are configured to overlap with the planarization layer.

17. The display device including the semiconductor light emitting device according to claim 1, further comprising a structure disposed within the first planarization layer, and
wherein the second assembly electrode is disposed on the structure.

18. The display device including the semiconductor light emitting device according to claim 17, wherein the contact electrode is configured to contact the second assembly electrode on an upper surface and a side surface.

19. The display device including the semiconductor light emitting device according to claim 1, further comprising a second insulating layer disposed on the contact electrode.

20. The display device including the semiconductor light emitting device according to claim 19, wherein the contact electrode and the second insulating layer are configured to surround the light emitting device.
